# EUROPEAN PATENT SPECIFICATION

(11) **EP 1 991 042 B1**
(45) Date of publication and mention of the grant of the patent: **29.06.2011**
(21) Application number: 08155536.9
(22) Date of filing: 01.05.2008
(51) Int. Cl.: H05K 7/20

(54) **Electrical circuit device**
Elektrische Schaltvorrichtung
Dispositif de circuit électrique

(30) Priority: 09.05.2007 JP 2007124951
(43) Date of publication of application: 12.11.2008
(73) Proprietor: FUJITSU TEN LIMITED, Kobe-shi, Hyogo 652-8510 (JP)
(72) Inventor: Hayakawa, Eisuke, Kobe-shi Hyogo 652-8510 (JP)
(74) Representative: Skone James, Robert Edmund

(56) References cited:
- DE-A1- 4 224 720
- DE-C1- 19 645 636
- DE-U1- 8 508 595
- JP-A- 10 044 657
- JP-A- 10 242 674
- JP-A- 2000 332 171
- JP-A- 2001 274 574

## Description

### BACKGROUND OF THE INVENTION

### 1. Field of the Invention

The present invention relates to an electrical circuit device of which at least a portion is hermetically sealed by a package, and, more particularly to an electrical circuit device that necessitates heat dissipation.

### 2. Description of the Related Art

For avoiding incorrect operations occurring due to dust or dirt that is entered into an existing electrical circuit, the existing electrical circuit is physically hermetically sealed by a package. However, upon hermetically sealing the electrical circuit, heat generated by electrical elements is internally retained, thus increasing internal atmospheric temperature.

Various existing technologies have been suggested for dissipating outside, heat generated by the electrical elements. For example, in the technology disclosed in Japanese Patent Application Laid-open No. H10-44657, by causing electronic components to contact a metallic casing, heat generated by the electronic components is emitted outside via the metallic casing.

In the technology disclosed in Japanese Patent Application Laid-open No. 2000-332171, heat generated by heating elements is emitted by sequentially transmitting to a through-hole for heat-dissipating fins, a heat-dissipating block, and a casing. Furthermore, in the technology disclosed in Japanese Patent Application Laid-open No. 2001-274574, a heating element package is arranged in an upper portion of an electrical enclosure and by causing a heat dissipation bottom portion to extend in a bottom wall direction of a lower casing, generated heat is emitted from the heating element package.

However, in the technologies mentioned above, if heat generated inside the package exceeds a heat dissipation capacity, generated heat is retained inside the package, thus increasing the atmospheric temperature. Due to this, radiation heat warms up components on a resin substrate to a temperature higher than an allowable temperature limit of the components, thereby degrading and damaging the components. Due to this, heat dissipation properties of heating components are worsened.

To be specific, because an in-vehicle electronic control unit (ECU) needs to be safely and reliably operated in a high temperature and in a highly dusty environment, hermetically sealing the in-vehicle electronic control unit (ECU) by using the package and heat dissipation are very important in the in-vehicle electronic control unit (ECU).

However, in an electronic control unit that drives a motor such as an electric power steering motor, a heating value of metal-oxide-semiconductor field-effect transistor (MOSFET) is high. Due to this, other electronic components are significantly affected.

Upon assuming that the temperature inside the package will increase, using an expensive component having high heat resistance properties is necessary, whereby a cost of an entire device increases. Furthermore, because a heat dissipation path from inside to outside of the package is to be built, a size of the entire device increases.

### SUMMARY OF THE INVENTION

It is an object of the present invention to at least partially solve the problems in the conventional technology.

According to the present invention, an electrical circuit device includes an electrical circuit that includes a plurality of electrically connected components including a component that necessitates heat measures;
a substrate that physically connects main components among the plural components of the electrical circuit; and
a package that hermetically seals the substrate,
the component that necessitates heat measures being arranged outside the package, and is characterized in that the electrical circuit device further comprises
a heat-dissipating member that is arranged outside the package, and
the component that necessitates heat measures is arranged in the heat-dissipating member, wherein
the heat-dissipating member has a heat conduction restraining structure for restraining heat conduction from the component that necessitates heat measures to the package.

The above and other objects, features, advantages and technical and industrial significance of this invention will be better understood by reading the following detailed description of presently preferred embodiments of the invention, when considered in connection with the accompanying drawings.

### BRIEF DESCRIPTION OF THE DRAWINGS

Fig. 1 is a schematic of an electronic control unit according to an embodiment of the present invention;
Fig. 2 is a schematic of an electronic control unit when a heating component is arranged inside a radiator plate;
Fig. 3 is a schematic for explaining a fixing method of a MOSFET;
Fig. 4 is a schematic for explaining how heat conduction from the MOSFET to a package is restrained by through-holes on the radiator plate;
Fig. 5 is a schematic for explaining how heat conduction from the MOSFET to the package is restrained by a transverse groove on the radiator plate;
Fig. 6 is a schematic for explaining how heat conduction from the MOSFET to the package is restrained by a spacer or a sheet of heat insulating material;
Fig. 7 is a schematic for explaining a structure in which the MOSFET is connected to a lead wire that is pulled out from a resin substrate;
Fig. 8 is a schematic for explaining a structure in which a plurality of components necessitating heat dissipation is pulled out outside the package as a module;
Fig. 9 is a schematic for explaining an example when a heat sink is not provided;
Fig. 10 is a schematic for explaining an example when an component necessitating heat dissipation is arranged outside by selectively forming the package with respect to a portion of a substrate;
Fig. 11 is a schematic for explaining an example when the component necessitating heat dissipation that is pulled out from the package is connected to another product, an electrical enclosure, or a vehicle; and
Fig. 12 is a schematic for explaining an example when a component that needs to be maintained at a low temperature is pulled out outside the package.

### DETAILED DESCRIPTION OF THE PREFERRED EMBODIMENTS

Exemplary embodiments of the electrical circuit device according to the present invention are explained in detail below with reference to the accompanying drawings.

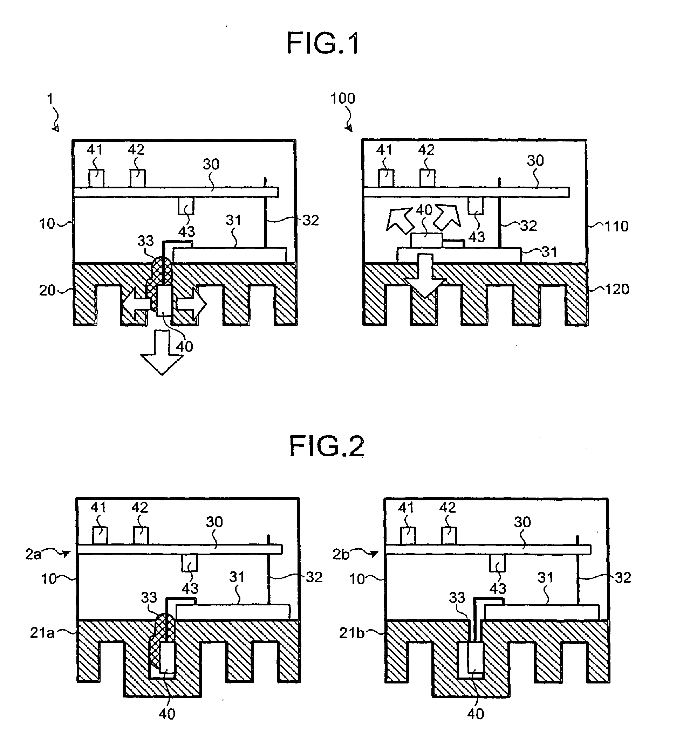

Fig. 1 is a schematic for explaining an electronic control unit (ECU) 1 for an electric power steering (EPS) according to an embodiment of the present invention in comparison with an existing electronic control unit 100. An electrical circuit of the existing electronic control unit 100 is formed of a metal-oxide-semiconductor field-effect transistor (MOSFET) 40 mounted on a metallic substrate 31 and components 41 to 43 mounted on a resin substrate 30.

The resin substrate 30 and the metallic substrate 31 are connected by a bus bar 32 and the entire electrical circuit is hermetically sealed by a package 110. By arranging a radiator plate 120, which is a type of a heat sink, in the package 110, heat dissipation of the electrical circuit is carried out.

In the ECU 100 for the EPS, heat generated by the MOSFET 40 affects other components most, thereby damaging and degrading the other components. In the electronic control unit 100, the MOSFET 40 is mounted on the metallic substrate 31 and is separated from the resin substrate 30. The radiator plate 120 is arranged in the vicinity of the metallic substrate 31. Thus, by using the structure mentioned earlier, from the heat generated by the MOSFET 40, an amount of heat emitted outside the package 110 is increased and an amount of heat within the package 110 is decreased.

In the existing structure, the heat dissipation path towards inside the package 110 exists because the MOSFET 40, which is a heating component, is arranged within the package 110. Hence, radiation heat warms up the components 41 to 43 mounted on the resin substrate 30 sometimes to a temperature higher than the allowable temperature limit of the components 41 to 43, thereby causing degradation of the components 41 to 43. To be specific, the life of an electrolyte capacitor that is weak in heat generation is shortened.

However, in the ECU 1 according to the embodiment of the present invention, the MOSFET 40 is pulled out outside a package 10 by a lead wire and is arranged in a radiator plate 20. Due to this, the MOSFET 40, which is the heating component, can be cooled by the external air.

An opening, which is arranged in the package 10 and the radiator plate 20 for pulling out the lead wire, is filled-in by a resin 33 (or sealing gel, high heat dissipation bond, etc.). Due to this, sealing properties of the package 10 are secured and insertion of outside dust is prevented.

Thus, without impairing functions of the package 10, heat generated by the MOSFET 40 is emitted outside the package 10. Due to this, increase in the internal atmospheric temperature can be avoided and heat dissipation properties of a heating component can be enhanced.

Because the components on the resin substrate are not affected by the radiation heat, the allowable temperature limit of the components can be lowered thus spec down of the components and reduction in a cost can be realized. In addition, a space inside the package is increased because the heating component, which is usually large in size, is arranged outside the package 10. Because the heating component is affected by the wind and the surrounding temperature is reduced, the heat dissipation properties of the heating component can be enhanced and the entire ECU 1 can be downsized.

The MOSFET 40 need not be always arranged outside a radiator plate. For example, in an electronic control unit 2a shown in Fig. 2, the MOSFET 40 is arranged in a space provided inside a radiator plate 21a. Thus, even if the heating component is arranged inside the radiator plate 21a, heat generated by the heating component is emitted outside the electronic control unit 2a via the radiator plate 21a because the heat conductivity of the radiator plate 21a is high.

In the electronic control unit 2a, the package 10 is sealed by closing the opening between an arrangement location of the MOSFET 40 and the package 10 by the resin 33. However, the arrangement location of the MOSFET 40 is separately arranged with respect to outside. When the MOSFET 40 is connected to the package 10 and the sealing properties inside the package 10 can be secured, the opening of the package 10 can be kept open, as shown in an electronic control unit 2b.

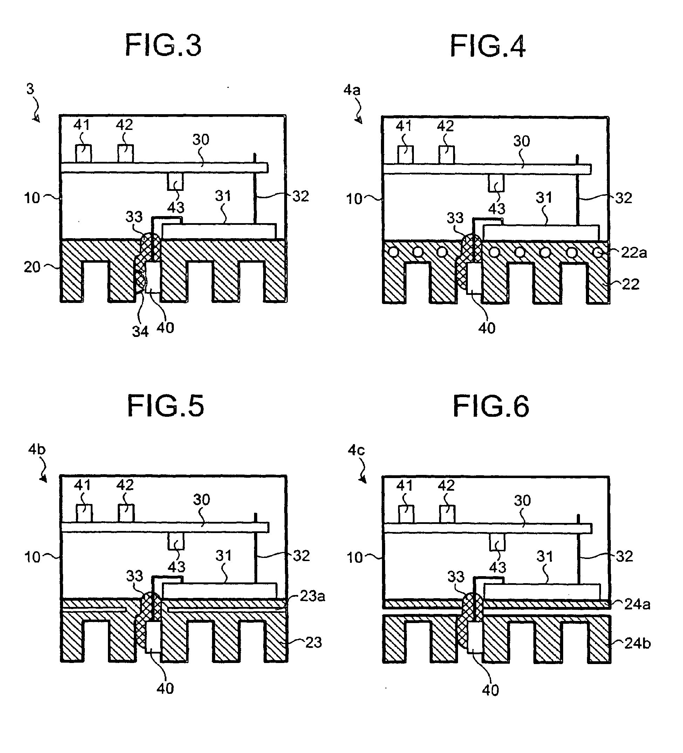

Any fixing method can be used for fixing the MOSFET 40 to the radiator plate. As shown in an electronic control unit 3 in Fig. 3, instead of screws, a retainer plate 34 that is provided in the radiator plate 20 can be used for fixing the MOSFET 40 to the radiator plate 20.

When the MOSFET 40 is fixed to the radiator plate 20, although most of the heat generated by the MOSFET 40 is emitted outside the electronic control unit 3, in other words, in the surrounding air, a heat conducting path from the radiator plate 20 to the package 10 exists.

Providing a heat transfer restraining structure for restraining heat conduction from a component necessitating heat dissipation (for example, the MOSFET 40) to the package 10 is desirable. In a specific example of an electronic control unit 4a shown in Fig. 4, through holes 22a are drilled between the arrangement location of the MOSFET 40 of a radiator plate 22 and a package connecting surface. Due to this, the heat conductivity from the MOSFET 40 to the package 10 is reduced.

Similarly, in an electronic control unit 4b shown in Fig. 5, a transverse groove 23a is arranged between the arrangement location of the MOSFET 40 of a radiator plate 23 and the package connecting surface. Due to this, the heat conductivity from the MOSFET 40 to the package 10 is reduced.

In an electronic control unit 4c shown in Fig. 6, the heat sink is divided into radiator plates 24a and 24b. By arranging a spacer or a sheet of a heat insulating material between the arrangement location of the MOSFET 40 of the radiator plate 24b and the package connecting surface, the heat conductivity from the MOSFET 40 to the package 10 is reduced.

In an electronic control unit 4c, the heat sink is divided and the spacer or the sheet of the heat insulating material is arranged. However, the spacer or the sheet of the heat insulating material can be arranged between the package and the heat sink.

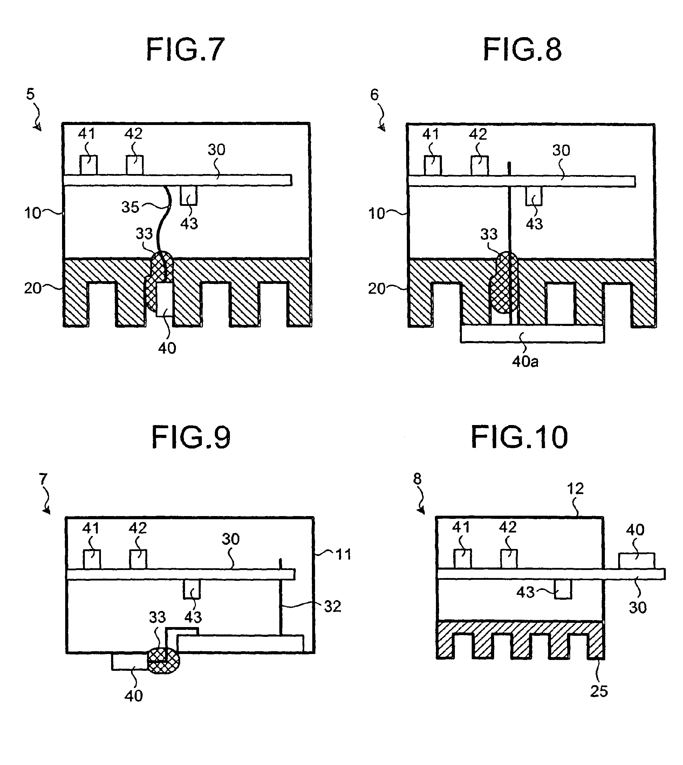

Modifications in the structure of the electronic control unit are explained herein. In an electronic control unit 5 shown in Fig. 7, the metallic substrate 31 and the bus bar is not included and the MOSFET 40 is pulled out from the resin substrate 30 by a lead wire 35. Furthermore, instead of the lead wire 35, a wire or the bus bar can be used.

In Fig. 8, a plurality of components necessitating heat dissipation including a MOSFET are arranged inside a module 40a. The module 40a is pulled out from the package 10 and is arranged on the radiator plate 20.

In an electronic control unit 7 shown in Fig. 9, the heat sink is not provided and the MOSFET 40, which is pulled out from a package 11, is arranged outside the package 11. In this structure, the heat sink is not provided, and a member necessitating heat dissipation is exposed in the external air. Due to this, heat dissipation is effectively carried out as compared to the MOSFET 40 that is arranged inside the package 10.

In an electronic control unit 8 shown in Fig. 10, similarly to the other components 41 to 43, the MOSFET 40 is mounted on the resin substrate 30. When forming a package 12, a formation location of the package 12 is controlled and the MOSFET 40 is mounted such that the MOSFET 40 is outside the package 12. In Fig. 10, although a radiator plate 25 is arranged separately from the MOSFET 40, the heat sink can be arranged such that the heat sink touches the MOSFET 40.

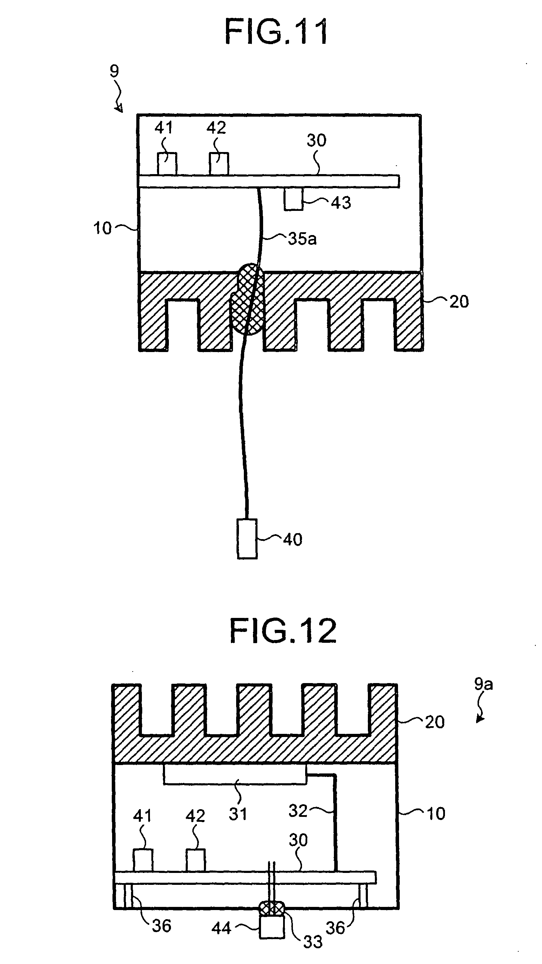

In an electronic control unit 9 shown in Fig. 11, the MOSFET 40 is pulled out by a long lead wire 35a. The MOSFET 40 is arranged at any position separately from the package 10 or the radiator plate 20. For example, the MOSFET 40 can be connected to another product, an electrical enclosure, or a vehicle.

In an electronic control unit 9a shown in Fig. 12, the heating component is arranged on the metallic substrate 31 in the vicinity of the radiator plate 20. An electrolyte capacitor 44 that needs to be maintained at a low temperature can be pulled out outside the package 10. In Fig. 12, the resin substrate 30 and the electrolyte capacitor 44 are separated by spacers 36. Due to this, the electrolyte capacitor 44 is not affected by the radiation heat of heat inside the package 10.

In the embodiments mentioned above, an example where the MOSFET in the ECU for the EPS is pulled out outside is explained. However, the present invention is not to be thus limited. The present invention can be widely applied for arranging the component necessitating heat dissipation in an electrical circuit device in which at least a portion of the electrical circuit device is hermetically sealed by the package.

The components necessitating heat dissipation are the heating elements having a high heating value at the time of operation as compared with other components and elements for which the surrounding temperature needs to be maintained at the low temperature as compared with other components.

For example, in the ECU for the EPS, apart from the MOSFET, a shunt resistance, a power smoothing coil or the electrolyte capacitor, and a relay are preferably pulled out outside as the components necessitating heat dissipation.

In a booster circuit, the MOSFET, the power smoothing coil or the electrolyte capacitor, and similarly, a boosting coil or the electrolyte capacitor, and rectifying diodes are the components necessitating heat dissipation.

In a pre-crash ECU, diodes used in a supplied current carrier for break lamp are preferably pulled out as the components necessitating heat dissipation.

Moreover, in a general ECU, transistor (for example, a supply circuit portion such as 5 volts (V) power supply), diodes (for example, the supply circuit portion such as 5 V power supply), a motor driving product, and heating components in a current supplying line (lamp, etc.) are the components necessitating heat dissipation.

In the electronic control unit according to the embodiment mentioned above, the MOSFET 40, which is the component necessitating heat dissipation, is pulled out outside the package 10 by the lead wire. Due to this, heat generated by the MOSFET 40 is emitted outside the package 10, thus increase in the internal atmospheric temperature is avoided and the heat dissipation properties of the heating component are enhanced.

Thus, the spec down of the component can be carried out and the cost can be reduced. By arranging the heating component, which is usually large in size, outside, the space inside the package is increased. Furthermore, due to the enhanced heat dissipation properties of the component necessitating heat dissipation, the electronic circuit unit can be downsized.

According to an embodiment of the present invention, a component that necessitates heat dissipation is arranged by pulling out outside a package. Due to this, increase in atmospheric temperature inside the package can be avoided and degradation or break down of an electrical circuit device can be prevented. Due to this, a cost can be reduced and an electrical enclosure of the electrical circuit device can be downsized.

Although the invention has been described with respect to specific embodiments for a complete and clear disclosure, the appended claims are not to be thus limited but are to be construed as embodying all modifications and alternative constructions that may occur to one skilled in the art that fairly fall within the basic teaching herein set forth.

## Claims

1. An electrical circuit device (1;2a;2b;3;4a;4b;4c;5;6;7;8;9;9a) comprising:
an electrical circuit that includes a plurality of electrically connected components (40,41,42,43) including a component (40) that necessitates heat measures;
a substrate (30) that physically connects main components (41,42,43) among the plural components (40,41,42,43) of the electrical circuit; and
a package (10;11;12) that hermetically seals the substrate (30),
the component (40;44) that necessitates heat measures being arranged outside the package (10;11;12), **characterized in that** the electrical circuit device (1;2a;2b;3;4a;4b;4c;5) further comprises
a heat-dissipating member (20;21a;21b;22;23;24a,24b;25) that is arranged outside the package (10), and
the component (40) that necessitates heat measures is arranged in the heat-dissipating member (20;21a;21b;22;23;24a,24b), wherein
the heat-dissipating member (22;23;24a,24b) has a heat conduction restraining structure (22a;23a) for restraining heat conduction from the component (40) that necessitates heat measures to the package (10).

2. The electrical circuit device (4c) according to claim 1, wherein
the heat conduction restraining structure of the heat-dissipating member (24a,24b) is configured with one of a spacer and a heat insulating material arranged between the component (40) that necessitates heat measures and the package (10).

3. The electrical circuit device (4a;4b;4c) according to claim 1, wherein
the heat conduction restraining structure (22a;23a) of the heat-dissipating member (22;23) is configured with one of a groove portion (23a) and a hole (22a) arranged between the component (40) that necessitates heat measures and the package (10).

4. The electrical circuit device (6) according to any one of claims 1 to 3, further comprising
a module (40a) that is arranged outside the package(10), the module (40a) necessitating heat measures and including plural components (40) that necessitate heat measures.

## Patentansprüche

1. Elektrische Schaltkreisvorrichtung (1; 2a; 2b; 3; 4a; 4b; 4c; 5; 6; 7; 8; 9; 9a), umfassend:
einen elektrischen Schaltkreis, der mehrere elektrisch verbundene Komponenten (40, 41, 42, 43) umfasst, die eine Komponente (40) umfassen, die Wärmemaßnahmen erfordert;
ein Substrat (30), das Hauptkomponenten (41, 42, 43) unter den mehreren Komponenten (40, 41, 42, 43) des elektrischen Schaltkreises physikalisch verbindet; und
ein Gehäuse (10; 11; 12), das das Substrat (30) hermetisch verschließt;
wobei die Komponente (40; 44), die Wärmemaßnahmen erfordert, außerhalb des Gehäuses (10; 11; 12) angeordnet ist,
**dadurch gekennzeichnet, dass** die elektrische Schaltkreisvorrichtung (1; 2a; 2b; 3; 4a; 4b; 4c; 5) ferner umfasst:
ein Wärmeableitelement (20; 21a; 21b; 22; 23; 24a; 24b; 25), das außerhalb des Gehäuses (10) angeordnet ist, und
die Komponente (40), die Wärmemaßnahmen erfordert, im Wärmeableitelement (20; 21a; 21b; 22; 23; 24a; 24b) angeordnet ist, wobei
das Wärmeableitelement (22; 23; 24a; 24b) eine die Wärmeleitung einschränkende Struktur (22a; 23a) zum Einschränken der Wärmeleitung von der Komponente (40), die Wärmemaßnahmen erfordert, zum Gehäuse (10) aufweist.

2. Elektrische Schaltkreisvorrichtung (4c) nach Anspruch 1, wobei
die die Wärmeleitung einschränkende Struktur des Wärmeableitelements (24a, 24b) mit einem von einem Distanzstück und einem Wärmedämmstoff ausgestaltet ist, das/der zwischen der Komponente (40), die Wärmemaßnahmen erfordert, und dem Gehäuse (10) angeordnet ist.

3. Elektrische Schaltkreisvorrichtung (4a; 4b; 4c) nach Anspruch 1, wobei
die die Wärmeleitung einschränkende Struktur (22a; 23a) des Wärmeableitelements (22; 23) mit einem von einem Rillenabschnitt (23a) und einem Loch (22a) ausgestaltet ist, der/das zwischen der Komponente (40), die Wärmemaßnahmen erfordert, und dem Gehäuse (10) angeordnet ist.

4. Elektrische Schaltkreisvorrichtung (6) nach einem der Ansprüche 1 bis 3, ferner umfassend:
ein Modul (40a), das außerhalb des Gehäuses (10) angeordnet ist, wobei das Modul (40a) Wärmemaßnahmen erfordert und mehrere Komponenten (40) umfasst, die Wärmemaßnahmen erfordern.

## Revendications

1. Dispositif à circuit électrique (1 ; 2a ; 2b ; 3 ; 4a ; 4b ; 4c ; 5 ; 6 ; 7 ; 8 ; 9 ; 9a) comportant :
un circuit électrique qui comprend une pluralité de composants connectés électriquement (40, 41, 42, 43) y compris un composant (40) qui nécessite des mesures de chaleur ;
un substrat (30) qui connecte physiquement les composants principaux (41, 42, 43) parmi les composants multiples (40, 41, 42, 43) du circuit électrique ; et
un boîtier (10 ; 11 ; 12) qui scelle hermétiquement le substrat (30),
le composant (40, 44) qui nécessite des mesures de chaleur étant disposé à l'extérieur du boîtier (10 ; 11 ; 12),
**caractérisé en ce que** le dispositif à circuit électrique (1 ; 2a ; 2b ; 3 ; 4a ; 4b ; 4c ; 5) comporte en outre
un élément dissipateur de chaleur (20 ; 21a; 21b ; 22 ; 23 ; 24a, 24b ; 25) qui est disposé à l'extérieur du boîtier (10), et
le composant (40) qui nécessite des mesures de chaleur est disposé dans l'élément dissipateur de chaleur (20 ; 21a; 21b ; 22 ; 23 ; 24a, 24b), dans lequel
l'élément dissipateur de chaleur (22 ; 23 ; 24a, 24b) a une structure limitant la conduction de chaleur (22a ; 23a) qui limite la conduction de chaleur entre le composant (40) qui nécessite des mesures de chaleur et le boîtier (10).

2. Dispositif à circuit électrique (4c) selon la revendication 1, dans lequel
la structure limitant la conduction de chaleur de l'élément dissipateur de chaleur (24a, 24b) est configurée avec soit une pièce d'écartement, soit.un isolant thermique disposé entre le composant (40) qui nécessite des mesures de chaleur et le boîtier (10).

3. Dispositif à circuit électrique (4a ; 4b ; 4c) selon la revendication 1, dans lequel
la structure limitant la conduction de chaleur (22a ; 23a) de l'élément dissipateur de chaleur (22 ; 23) est configurée avec soit une partie rainure (23a), soit un trou (22a) disposé entre le composant (40) qui nécessite des mesures de chaleur et le boîtier (10).

4. Dispositif à circuit électrique (6) selon l'une quelconque des revendications 1 à 3, comportant en outre
un module (40a) qui est disposé à l'extérieur du boîtier (10), ce module (40a) nécessitant des mesures de chaleur et comprenant des composants multiples (40) qui nécessitent des mesures de chaleur.
